# EUROPÄISCHE PATENTANMELDUNG

(11) **EP 2 360 730 A2**
(43) Veröffentlichungstag der Anmeldung: **24.08.2011**
(21) Anmeldenummer: 11001346.3
(22) Anmeldetag: 18.02.2011
(51) Int. Cl.: H01L 31/0216

(54) **Halbleiterbauelement mit photonischer Strukturierung sowie Verwendungsmöglichkeiten**

(30) Priorität: 23.02.2010 DE 102010008904
(71) Anmelder: Fraunhofer-Gesellschaft zur Förderung der angewandten Forschung e.V., 80686 München (DE)
(72) Erfinder: Peters, Marius, 79110 Freiburg (DE); Bläsi, Benedikt, 79104 Freuburg (DE); Goldschmidt, Jan Christoph, 79100 Freiburg (DE)
(74) Vertreter: Pfenning, Meinig & Partner GbR

(57) **Zusammenfassung**

Die vorliegende Erfindung betrifft ein Halbleiterbauelement, das ein Halbleitermaterial mit einem p-n-Übergang aufweist, wobei das Halbleitermaterial zusätzlich zu dem Halbleitermaterial inhärenten elektronischen Bandlücke eine photonische Bandlücke aufweist. Insbesondere betrifft die vorliegende Erfindung eine Solarzelle, umfassend oder bestehend aus einem eine photonische Bandlücke aufweisenden Halbleitermaterial.

## Beschreibung

Die vorliegende Erfindung betrifft ein Halbleiterbauelement, das ein Halbleitermaterial mit einem p-n-Übergang aufweist, wobei das Halbleitermaterial zusätzlich zu dem Halbleitermaterial inhärenten elektronischen Bandlücke eine photonische Bandlücke aufweist. Insbesondere betrifft die vorliegende Erfindung eine Solarzelle, umfassend oder bestehend aus einem eine photonische Bandlücke aufweisenden Halbleitermaterial.

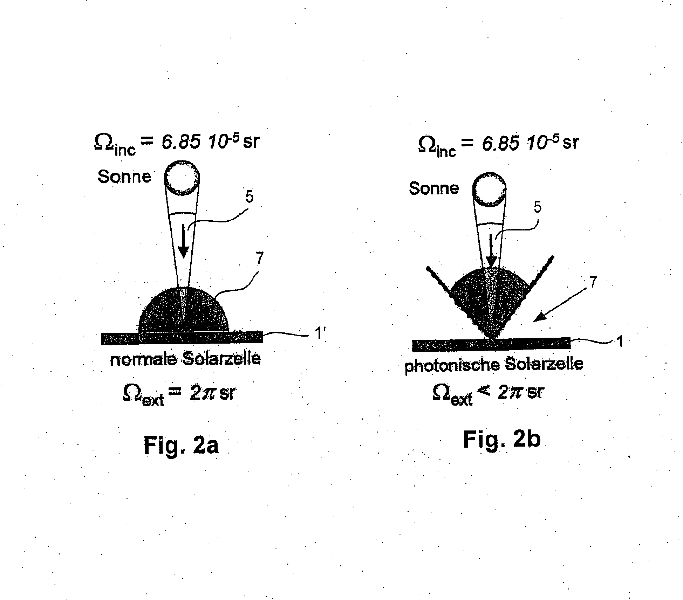

Ein Verlustmechanismus bei Solarzellen ist dadurch gegeben, dass es einen Unterschied zwischen dem Phasenraumvolumen der einfallenden Strahlung und der emittierten Strahlung gibt (siehe auch Fig. 2a). Die Sonne gibt zu jedem Zeitpunkt an die Solarzelle Strahlung nur aus einem sehr kleinen Raumwinkelbereich ab, die Solarzelle emittiert jedoch in den kompletten Halbraum. Dieser Mechanismus sorgt für eine Generation von Entropie und damit verbunden zu einer Reduktion der Effizienz (Theorem von Gouy Stodola). Diesem Verlust kann entgegengewirkt werden, indem die Raumwinkelbereich aus dem absorbiert bzw. in welchen emittiert wird verändert werden. Eine Möglichkeit besteht darin, die Sonnenscheibe aus sicht der Solarzelle zu vergrößern (Konzentration). Eine weitere Möglichkeit besteht darin die Raumrichtung der Emission der Solarzelle einzuschränken (Einschränkung der Winkelakzeptanz).

Nach dem Stand der Technik gibt es verschiedene Möglichkeiten die Emission einer Solarzelle in verschiedene Winkelbereiche einzuschränken. Zum einen ist der Einsatz winkelselektiver Filter möglich (siehe z.B. WO 2009/071300 A).

Eine andere Möglichkeit besteht darin eine Oberflächenform zu finden, die zu einer Vorwärtsgerichteten Emission führt (siehe J. Phys. D: Appl. Phys. 38 (2005) 2166-2172, Spectrally and angularly selective photothermal and photovoltaic converters under onesun illumination, V. Badescu).

Eine weitere Möglichkeit besteht in der Verwendung von Quantum Wells (siehe J. Adams, Efficiency enhancement in strain-balanced quantum well solar cells via anisotropic emission, Proceedings of the 24th PVSEC, Hamburg, 2009). Dabei wird die Beeinflussung der winkelabhängigen Emission durch eine Polarisationsabhängigkeit von Quantentöpfen erreicht.

Die Nachteile der bisher bekannten oben genannten Konzepte liegen darin, dass beispielsweise bei Einsatz von Filtern nicht die Gesamtheit des einfallenden Lichts verwendet werden kann, so dass der maximale Wirkungsgrad einer derartig konstruierten Solarzelle merklich durch den Lichtverlust reduziert wird. Weiterhin gehen mit dem zweiten oben genannten Lösungsansatz, bei dem eine spezielle Oberflächenform auf eine Solarzelle aufgebracht wird, die Nachteile einher, dass trotz einer gewissen Winkelselektivität nach wie vor Strahlungsverluste durch Reflexion und Emission über die Oberfläche der Solarzelle erfolgen. Die Verwendung von Quantentöpfen (quantum wells) birgt den Nachteil, dass eine derartige Strukturierung äußerst schwierig zu realisieren und praktisch umzusetzen ist. Quantentöpfe sind wegen ihrer sehr geringen Ausdehnung aufwändig in der Herstellung.

Ausgehend von den oben genannten Nachteile ist es daher Aufgabe der vorliegenden Erfindung, ein Halbleiterbauelement anzugeben, mit dem die Emission der von der Solarzelle emittierten Strahlung so weit wie möglich unterbunden werden kann und somit die Strahlungsausbeute bzw. die Effizienz eines derartigen Bauteils gegenüber aus dem Stand der Technik bekannten Lösungen merklich erhöht werden kann.

Diese Aufgabe wird bezüglich des Halbleiterbauelements mit den Merkmalen des Patentanspruchs 1 gelöst. Mit Patentanspruch 15 werden Verwendungszwecke eines erfindungsgemäßen Halbleiterbauelements angegeben. Die abhängigen Patentansprüche stellen dabei vorteilhafte Weiterbildungen dar.

Erfindungsgemäß wird somit ein Halbleiter-Bauelement angegeben, das mindestens ein Halbleitermaterial mit einem p-n-Übergang umfasst, wobei das Halbleitermaterial eine photonische Strukturierung aufweist.

Ein photonischer Kristall oder eine photonische Struktur ist ein Material, bei dem die Dispersion der Photonen innerhalb des Materials durch dessen Struktur vorgegeben wird. Die Effekte, die für Photonen im photonischen Kristall auftreten, sind vergleichbar denen von Elektronen in einem Halbleiterkristall. Aus dieser Analogie bezieht der photonische Kristall seinen Namen als auch seine physikalische Beschreibung. Ähnlich wie für die Elektronen im Halbleiter bildet sich für die Photonen im photonischen Kristall eine Bandstruktur aus. Ein Band bezeichnet eine Region von Photonen bestimmter Energien und bestimmter Richtungen, die innerhalb des photonischen Kristalls nicht existieren können. Dies führt dazu, dass innerhalb des Bandes keine Photonen von außen in den Kristall hinein können (er reflektiert perfekt) und dass von innen keine Photonen hinaus können (die Emission ist unterdrückt). Unterschieden wird zwischen vollständigen und unvollständigen Bändern. In einem vollständigen Band sind für Photonen bestimmte Energien alle Richtungen ausgeschlossen, in einem unvollständigen Band sind manche Richtungen erlaubt, andere nicht. Ein photonischer Kristall kann sowohl vollständige als auch unvollständige Bänder enthalten.

Die zuvor zitierte WO 2009/071300 verwendet ein externes Element (Filter), welches durch die Solarzelle emittierte Strahlung lediglich zurückwerfen, nicht aber unterdrücken kann. Im Gegensatz dazu wird in der vorliegenden Erfindung eine Emission direkt in der Solarzelle unterdrückt und kein zusätzliches Element verwendet. Hierin liegt der wesentliche Vorteil der beschriebenen Erfindung; eine direkte Unterdrückung der Emission ist gegenüber der lediglichen Rückgewinnung emittierter Strahlung deutlich effizienter.

Der wesentliche Unterschied zur zuvor beschriebenen Möglichkeit, eine vorwärts gerichtete Emission durch Oberflächenstrukturierung zu erzielen, besteht darin, dass in der zitierten Veröffentlichung die Winkelselektivität durch eine nicht genauer spezifizierte Oberfläche erreicht werden soll wohingegen in der vorliegenden Erfindung ein Effekt im Volumen ausgenutzt wird, wodurch die Emission von Strahlung weit effizienter unterbunden werden kann. Dadurch ist eine deutliche Steigerung des Wirkungsgrades des erfindungsgemäßen Halbleiterbauelements zu erwarten.

Gegenüber der zuvor vorgestellten Möglichkeit der Verwendung von Quantentöpfen, deren typische Strukturgrößen sich von photonischen Strukturen um Größenordnungen unterscheiden und deren zu Grunde liegende physikalischen Effekte von denen, welche in photonischen Strukturen auftreten, fundamental unterschiedlich sind, liegt der Vorteil der vorliegenden Erfindung darin, dass durch die wesentlich größeren Strukturen der photonischen Kristalle eine einfachere Fertigung zu erwarten ist. Der Vorteil gegenüber Quantentöpfen liegt auch in einer potentiell effizienteren Unterdrückung der Emission.

Der besondere Vorteil des erfindungsgemäßen Halbleiterbauelements liegt somit darin, dass eine Einschränkung der Richtungen erreicht wird, in welche ein opto-elektronisches Bauteil emittieren kann. Dadurch wird der durch Emission bedingte Lichtverlust deutlich gemindert.

Mit anderen Worten bedeutet dies, dass Strahlung, welche das Halbleiter-Bauelement emittiert, nur noch unter ganz bestimmten Winkeln austreten kann, ergo emittiert werden kann. Durch die Einschränkung des Winkels, unter denen eine erneute Emission einmal eingefallener Strahlung aus dem Halbleiter-Bauelement erfolgen kann, wird eine deutliche Effizienzsteigerung der Quantenausbeute des Halbleiter-Bauelements erzielt. Zudem ändert sich auch die thermodynamische Gesamtsituation vorteilhaft. Insbesondere im Beispiel einer Solarzelle kann dies durch eine Kombination einer Solarzelle mit einer photonischen Struktur zu einer photonischen Solarzelle erfolgen. Die Struktur ändert die Emissionseigenschaften der Solarzelle dahingehend, dass die Lichtausbeute der Solarzelle deutlich erhöht wird. Kennzeichnend ist die Anwesenheit einer photonischen Bandlücke, die die Emission von Licht in mindestens eine Richtung unterdrückt oder merklich reduziert.

Durch die photonische Strukturierung des Halbleiterbauelements ergibt sich somit eine photonische Bandlücke, die zu vollständigen bzw. unvollständigen Bändern führen kann. Insbesondere eine zu unvollständigen Bändern führende photonische Strukturierung ist erfindungsgemäß besonders bevorzugt.

Eine vorteilhafte photonische Strukturierung kann dabei in Form eines Bragg-Stapels, als zwei- oder dreidimensionaler photonischer Kristall, in Form eines Bündels photonischer Kristallfasern, als aperiodisches Dünnschichtsystem oder als Kantenfilter erfolgen.

Ein Bragg-Stapel stellt dabei eine schichtweise periodische Abfolge zweier Materialien mit unterschiedlichen optischen Brechungsindizes dar. In einer bevorzugten Ausführungsform der vorliegenden Erfindung ist der Bragg-Stapel dabei aus zwei unterschiedlichen Halbleitermaterialien mit verschiedenen optischen Brechungsindizes gebildet, wobei die Dicke der beiden Halbleitermaterial-Lagen zwischen 10 und 1000 nm, bevorzugt zwischen 10 und 700 nm, besonders bevorzugt zwischen 15 und 500 nm beträgt. Insbesondere im Hinblick auf Solarzellen ist es sinnvoll, Materialien mit kleinen Unterschieden der Brechungsindizes zu verwenden. Die oben genannten Schichtdicken sind allerdings lediglich beispielhaft zu verstehen und erfindungsgemäß besonders bevorzugt. Selbstverständlich können auch dünnere oder dickere Schichten verwendet werden, so lange sich damit Bragg-Stapel herstellen lassen.

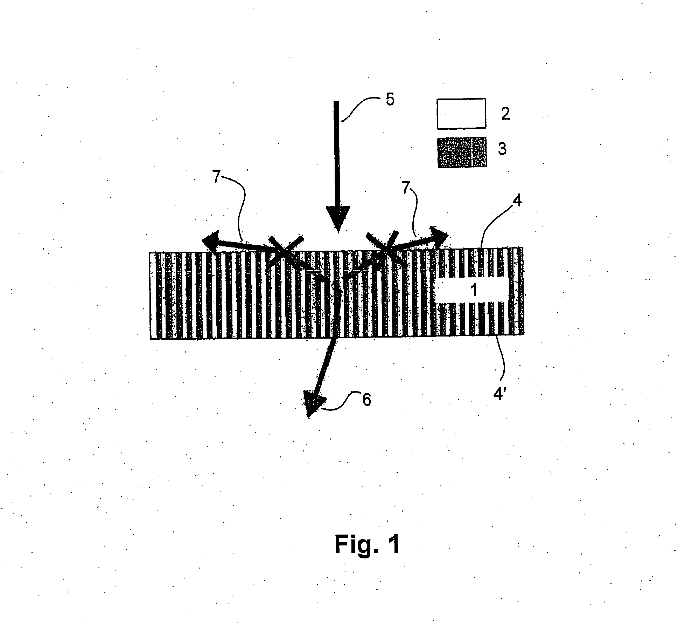

Bei einer schichtartigen, quaderförmigen oder länglichen Ausbildung des Halbleiterbauelements ist es insbesondere von Vorteil, wenn die Halbleiterlagen des Bragg-Stapels verkippt, d.h. nicht z.B. in der Längsrichtung verlaufend, sondern in einem Winkel von 90° ± 10° bezüglich der Längsrichtung des Halbleiter-Bauelements angeordnet sind, d.h. die Halbleiterlagen verlaufen bevorzugt in Richtung der Flächennormalen ± 10° einer derartigen Schicht bzw. eines Quaders. Die Lagen des Bragg-Stapels sind somit auf die Fläche ausgerichtet, die dem Lichteinfall dient. Diese bevorzugte Ausführungsform wird nachgehend insbesondere im Zusammenhang mit der beigefügten Figur 1 näher erläutert. Dadurch ergibt sich auch bei kleinen Brechungsindizesunterschieden eine sehr hohe Reflexion und eine Emission wird insbesondere in Richtung parallel zur einfallenden Strahlung unterdrückt.

Bei den zwei- oder dreidimensionalen photonischen Strukturierungen bzw. photonischen Kristallen ist es bevorzugt, dass deren Gitterkonstante zwischen 10 bis 1500 nm, bevorzugt zwischen 10 und 1200 nm, insbesondere zwischen 15 und 1000 nm beträgt. Diese Werte sind beispielhafter Natur, auch größere und kleinere Strukturen sind erfindungsgemäß umfasst.

Besonders bevorzugte photonische Strukturierungen bzw. photonische Kristalle weisen dabei die Struktur eines invertierten Opals auf. Dieser invertierte Opal kann dabei in zwei oder drei Dimensionen im Halbleitermaterial realisiert sein. Invertierte Opale stellen dabei eine regelmäßige Anordnung von sphärischen Hohlräumen, die von festen Zwischenwänden des Halbleitermaterials umgeben sind, dar.

Bevorzugt weisen die im invertierten Opal vorhandenen Hohlräume einen mittleren Durchmesser d₅₀ zwischen 10 und 1500 nm, bevorzugt zwischen 10 und 1200 nm, besonders bevorzugt zwischen 15 und 1000 nm auf. Diese Werte sind beispielhafter Natur, auch größere und kleinere Strukturen sind erfindungsgemäß umfasst.

Vorteilhafte Halbleitermaterialien, die für das Halbleiterbauelement verwendet werden können, sind dabei ausgewählt aus der Gruppe bestehend aus IV-Halbleitern, III-V-Halbleitern, II-VI-Halbleitern, III-VI-Halbleitern, I-III-VI-Halbleitern, IV-IV-Halbleitern und/oder Kombinationen hieraus.

Insbesondere können für die zuvor genannten Halbleitermaterialien die folgenden spezifischen Halbleiter verwendet werden:
a) IV-Halbleiter: Si und/oder Ge,
b) III-V-Halbleiter: GaP, GaAs, InP, InSb, InAs, GaSb, GaN, AlN, InN, AlₓGa₁₋ₓAs, InₓGa₁₋ₓN, und/oder Kombinationen hieraus,
c) II-VI-Halbleiter: ZnO, ZnS, ZnSe, ZnTe, CdS, CdSe, CdTe, Hg₍₁₋ₓ₎Cd₍ₓ₎Te, BeSe, BeTe, HgS und/oder Kombinationen hieraus,
d) III-VI-Halbleiter: GaS, GaSe, GaTe, InS, InSe, InTe und/oder Kombinationen hieraus,
e) I-III-VI-Halbleiter: CuInSe₂, CuInGaSe₂, CuInS₂, CuInGaS₂ und/oder Kombinationen hieraus,
f) IV-IV-Halbleiter: SiC und/oder SiGe, und/oder
g) chemischen Verbindungen der zuvor genannten Halbleitermaterialien, d.h. insbesondere ternäre oder quaternäre Halbleiter.

Weiter ist bevorzugt, dass das Halbleitermaterial als Schicht, schichtähnliche Struktur oder Bereich, ausgebildet ist und auf der ersten flächig ausgebildeten Seite eine n-Dotierung und auf der der ersten flächigen Seite gegenüberliegenden Seite eine p-Dotierung aufweist oder auf der ersten flächig ausgebildeten Seite eine p-Dotierung und auf der der ersten flächigen Seite gegenüberliegenden Seite eine n-Dotierung aufweist. In dieser bevorzugten Ausführungsform weist das Halbleitermaterial von der einen Seite, ausgehend von der Oberfläche eine n-Dotierung auf, die bis in eine gewisse Schichttiefe des Halbleitermaterials reicht, ohne jedoch bis auf die gegenüberliegende Seite durchgängig ausgebildet zu sein. Die andere Seite des Halbleitermaterials ist dabei p-dotiert, wobei auch die von dieser anderen Seite ausgehende p-Dotierung nicht bis zur gegenüberliegenden Seite ausgebildet ist. Bevorzugt sind die Tiefen der Dotierungen so gewählt, dass ca. in der Mitte der Schicht, d.h. auf ca. halber Schichtdicke, ein Bereich vorliegt, der im Wesentlichen undotiert ist.

In einer weiteren vorteilhaften Ausführungsform weisen die beiden flächigen Seiten der Schicht jeweils Mittel zur elektrischen Kontaktierung auf.

Insbesondere für den Fall, dass das Halbleiterbauelement in einer Solarzelle oder als Solarzelle verwendet wird, ist es bevorzugt, dass die erste Seite, d.h. die Seite, die eine n-Dotierung aufweist, eine Antireflexbeschichtung aufweist. Alternativ oder zusätzlich hierzu ist es möglich, dass das Halbleiterbauelement in einem Kunststoff verkapselt vorliegt.

Insbesondere kann das Halbleiterbauelement als Solarzelle, Diode, Leuchtdiode, Laserdiode, Sensor oder Bauelement der Informationstechnologie ausgebildet sein oder als ein derartiges Bauteil verwendet werden.

Die vorliegende Erfindung wird anhand der nachfolgend beigefügten Figuren sowie den Ausführungen näher erläutert, ohne die Erfindung auf die speziell dargestellten Ausführungsformen zu beschränken.

Dabei zeigen
- Figur 1: eine Skizze eines erfindungsgemäßen Halbleiter-Bauelements, insbesondere in einer Ausbildung als Solarzelle, sowie
- Figur 2: das vorteilhafte Funktionsprinzip einer erfindungsgemäßen photonischen Solarzelle.

Gegenstand der Erfindung ist ein opto-elektronisches Element bei dem die Winkelakzeptanz dadurch eingeschränkt wird, dass dieses Element in Form einer photonischen Struktur gefertigt wird (im Folgenden als photonische Solarzelle bezeichnet). Dazu wird z.B. eine photonische Struktur mit einem unvollständigen Band benötigt. Dieses Band muss so geartet sein, dass es Licht welches aus Richtung der Sonne auf die photonische Solarzelle einfällt passieren lässt. Der zugehörige Raumwinkel sei mit Ω1 bezeichnet. Weiterhin soll die photonische Solarzelle einen von Ω 1 verschiedenen Raumwinkelbereich Ω2 aufweisen, in welchem das Band eine Emission der Solarzelle verhindert. Eine Konsequenz hiervon ist, dass wegen der geänderten thermodynamischen Situation die Solarzelle einen höheren Wirkungsgrad erreichen kann.

In Figur 1 ist ein Beispiel eines erfindungsgemäßen Halbleiterbauelements 1 dargestellt, das beispielsweise als Solarzelle verwendet werden kann. Das in Figur 1 dargestellte Halbleiterbauelement ist dabei quaderförmig aufgebaut, und besteht aus zwei Materialien 2 und 3, die unterschiedliche optische Brechungsindizes aufweisen. Die Materialien 2 und 3 sind dabei mit gleicher Schichtdicke aneinandergefügt, so dass ein Bragg-Stapel ausgebildet wird. Der Bragg-Stapel ist dabei um 90° gegen die Einfallsrichtung 4 des einfallenden Lichts, beispielsweise Sonnenlicht, gekippt. Bezüglich der ersten Oberfläche 4 bzw. der zweiten, rückseitigen Oberfläche 4' verlaufen die Materialschichten 2 und 3 dabei vorzugsweise in Richtung der jeweiligen Flächennormalen.

Der Bragg-Stapel besteht aus zwei Solarzellenmaterialien mit verschiedenen Brechungsindizes. Dabei reichen bereits leichte Unterschiede aus, da bei einer großen Fläche viele Perioden möglich sind. Ein mögliches Beispiel wäre eine Bulk-Heterojunction Solarzelle. Durch den Bragg-Stapel ist eine Absorption und Emission im Winkelbereich des einfallenden Lichtes möglich, nicht aber in Richtungen 90° verkippt zum Einfall.

Durch die erfindungsgemäße Anordnung gemäß Figur 1 wird somit eine photonische Bandlücke im Halbleiterbauelement 1 erzeugt. Dies führt dazu, dass einfallendes Licht 5 im Wesentlichen nur in Richtung des Pfeils 6 durch das Halbleiterbauelement durchtreten kann. Eine Reemission in Richtung der angedeuteten Pfeile 7 ist dabei aufgrund der photonischen Bandlücke nicht erlaubt. Mit einem derartigen Halbleiterbauelement 1 wird somit ein Lichtverlust über die Oberfläche, wie dies durch die Pfeile 7 angedeutet ist, unterbunden, so dass eine deutliche Lichteffizienz des durchtretenden Sonnenlichts 6 erreicht wird. Insbesondere bieten sich somit Vorteile bei der Verwendung als Solarzelle, als Leuchtdiode oder als richtungssensitiver Sensor.

Das Halbleiterbauelement 1 kann im Bereich der Oberfläche 4 n-dotiert sein, die Rückseitenoberfläche 4' kann dabei p-dotiert sein. Die Dotierung erfolgt dabei nicht durch die gesamte Dicke des Halbleiterbauelements 1 hindurch, sondern lediglich den Bereichen gewisser Eindringtiefe in das Halbleiterbauelement 1. Ebenso können die Oberflächen 4 mit Kontaktelementen, z.B. Busbars, versehen sein, während die Rückseite ebenso Elemente zur Kontaktierung 4' aufweisen kann, wodurch sich das Halbleiter-Bauelement als elektronisches Bauteil, insbesondere als Solarzelle verwenden lässt.

In den Figuren 2a und 2b ist der Effekt, der sich beispielsweise bei einer erfindungsgemäßen photonischen Solarzelle (Figur 2b) im Vergleich zu einer normalen Solarzelle (Figur 2a) einstellt, dargestellt. Beide Solarzellen werden hier durch Sonnenstrahlung 5 bestrahlt. Mit Ω_{inc} ist der typische Einfallswinkel des Sonnenlichts dargestellt. Bei einer normalen Solarzelle 1', wie sie in Figur 2a dargestellt ist, beträgt der Winkel, unter dem Licht der Solarzelle emittiert werden kann (Ωₑₓₜ) den kompletten Raumwinkel, d.h. 180°. Die emittierten Lichtrichtungen sind dabei mit dem Referenzzeichen 7 bezeichnet. Bei einer Solarzelle 2b, die ein erfindungsgemäßes Halbleiterbauelement 1 beinhaltet, erfolgt eine Unterdrückung der Emission unter bestimmten Frequenzen und Winkelbereichen. Die fehlende Emission von Licht ist hier ebenso mit dem Bezugszeichen 7 angedeutet. Die zugrunde liegende photonische Solarzelle kann beispielsweise ein Halbleiterbauelement 1, wie es in Figur 1 dargestellt ist, sein. Eine derartige Ausgestaltung hat Auswirkung auf das thermodynamische Wirkungsgradlimit der Solarzelle, das erfindungsgemäß deutlich erhöht wird.

## Patentansprüche

1. Halbleiter-Bauelement (1), umfassend mindestens ein Halbleitermaterial mit einem p-n-Übergang, wobei das Halbleitermaterial eine photonische Strukturierung aufweist.

2. Halbleiter-Bauelement (1) nach Anspruch 1, **dadurch gekennzeichnet, dass** es eine photonische Bandlücke aufweist.

3. Halbleiter-Bauelement (1) nach einem der vorhergehenden Ansprüche, **dadurch gekennzeichnet, dass** die photonische Strukturierung in Form eines Bragg-Stapels, als zwei- oder dreidimensionaler photonischer Kristall, in Form eines Bündels photonischer Kristallfasern, als aperiodisches Dünnschichtsystem oder als Kantenfilter ausgebildet ist.

4. Halbleiter-Bauelement (1) nach vorhergehendem Anspruch, **dadurch gekennzeichnet, dass** der Bragg-Stapel durch periodische Abfolge zweier Halbleitermaterial-Lagen mit unterschiedlichen optischen Brechungsindices gebildet ist, wobei die Dicke der beiden Halbleitermaterial-Lagen bevorzugt zwischen 10 und 1000 nm, weiter bevorzugt zwischen 10 und 700 nm, besonders bevorzugt zwischen 15 und 500 nm beträgt.

5. Halbleiter-Bauelement (1) nach Anspruch 4, **dadurch gekennzeichnet, dass** die beiden Halbleiterlagen in einem Winkel von 90° ± 10° bezüglich der Längsrichtung des Halbleiter-Bauelements (1) angeordnet sind.

6. Halbleiter-Bauelement (1) nach Anspruch 3, **dadurch gekennzeichnet, dass** der zwei- oder dreidimensionale photonische Kristall eine Gitterkonstante von 10 bis 1500 nm, bevorzugt von 10 bis 1200 nm, insbesondere von 15 bis 1000 nm aufweist.

7. Halbleiter-Bauelement (1) nach Anspruch 3 oder 6, **dadurch gekennzeichnet, dass** der zwei- oder dreidimensionale photonische Kristall eine Struktur eines invertierten Opals aufweist.

8. Halbleiter-Bauelement (1) nach vorhergehendem Anspruch, **dadurch gekennzeichnet, dass** die im invertierten Opal vorhandenen Hohlräume einen mittleren Durchmesser d₅₀ zwischen 10 und 1500 nm, bevorzugt zwischen 10 und 1200 nm, besonders bevorzugt zwischen 15 und 1000 nm aufweisen.

9. Halbleiter-Bauelement (1) nach einem der vorhergehenden Ansprüche, **dadurch gekennzeichnet, dass** das Halbleitermaterial ausgewählt ist aus der Gruppe bestehend aus IV-Halbleitern, III-V-Halbleitern, II-VI-Halbleitern, III-VI-Halbleitern, I-III-VI-Halbleitern, IV-IV-Halbleitern und/oder Kombinationen hieraus.

10. Halbleiter-Bauelement (1) nach einem der vorhergehenden Ansprüche, **dadurch gekennzeichnet, dass** die
a) IV-Halbleiter ausgewählt sind aus der Gruppe bestehend aus Si und/oder Ge,
b) III-V-Halbleiter ausgewählt sind aus der Gruppe bestehend aus GaP, GaAs, InP, InSb, InAs, GaSb, GaN, AlN, InN, AlₓGa₁₋ₓAs, InₓGa₁₋ₓN, und/oder Kombinationen hieraus,
c) II-VI-Halbleiter ausgewählt aus der Gruppe bestehend aus ZnO, ZnS, ZnSe, ZnTe, CdS, CdSe, CdTe, Hg₍₁₋ₓ₎Cd₍ₓ₎Te, BeSe, BeTe, HgS und/oder Kombinationen hieraus,
d) III-VI-Halbleiter ausgewählt aus der Gruppe bestehend aus GaS, GaSe, GaTe, InS, InSe, InTe und/oder Kombinationen hieraus,
e) I-III-VI-Halbleiter ausgewählt aus der Gruppe bestehend aus CuInSe₂, CuInGaSe₂, CuInS₂, CuInGaS₂ und/oder Kombinationen hieraus,
f) IV-IV-Halbleiter ausgewählt aus der Gruppe bestehend aus SiC und/oder SiGe, und/oder
g) chemischen Verbindungen der zuvor genannten Halbleitermaterialien.

11. Halbleiter-Bauelement (1) nach einem der vorhergehenden Ansprüche, **dadurch gekennzeichnet, dass** das Halbleitermaterial als Schicht, schichtähnliche Struktur oder Bereich ausgebildet ist und auf der ersten flächig ausgebildeten Seite eine n-Dotierung und auf der der ersten flächigen Seite gegenüberliegenden Seite eine p-Dotierung aufweist oder auf der ersten flächig ausgebildeten Seite eine p-Dotierung und auf der der ersten flächigen Seite gegenüberliegenden Seite eine n-Dotierung aufweist.

12. Halbleiter-Bauelement (1) nach vorhergehendem Anspruch, **dadurch gekennzeichnet, dass** die beiden flächigen Seiten der Schicht jeweils Mittel zur elektrischen Kontaktierung aufweisen.

13. Halbleiter-Bauelement (1) nach einem der beiden vorhergehenden Ansprüche, **dadurch gekennzeichnet, dass** auf der ersten Seite eine Antireflexbeschichtung aufgebracht ist und/oder das Halbleiter-Bauelement in einem Kunststoff verkapselt vorliegt.

14. Halbleiter-Bauelement (1) nach einem der vorhergehenden Ansprüche in Form einer Solarzelle, Diode, Leuchtdiode, Laserdiode, Sensor oder Bauelement der Informationstechnologie.

15. Verwendung eines Halbleiter-Bauelements (1) nach einem der vorhergehenden Ansprüche als Solarzelle, Diode, Leuchtdiode, Laserdiode, Sensor oder Bauelement der Informationstechnologie.
